Europäisches Patentamt

European Patent Office

Office européen des brevets

(11) Numéro de publication: **0 373 030**
**A1**

## (12) DEMANDE DE BREVET EUROPEEN

(21) Numéro de dépôt: 89403260.6

(22) Date de dépôt: 24.11.89

(51) Int. Cl.5: **H03F 3/58, H03F 3/56**

(30) Priorité: 30.11.88 FR 8815672

(43) Date de publication de la demande:
**13.06.90 Bulletin 90/24**

(84) Etats contractants désignés:
**DE GB IT NL**

(71) Demandeur: **THOMSON-CSF**
**51, Esplanade du Général de Gaulle**
**F-92800 Puteaux(FR)**

(72) Inventeur: **Rambert, Bernard**
**THOMSON-CSF SCPI Cédex 67**
**F-92045 Paris la Défense(FR)**

(74) Mandataire: **Albert, Claude et al**
**THOMSON-CSF SCPI**
**F-92045 PARIS LA DEFENSE CEDEX 67(FR)**

(54) **Alimentation régulée en tension pour tubes hyperfréquences.**

(57) L'invention concerne un ensemble d'alimentation pour un tube du type nécessitant à la fois une alimentation de cathode et une alimentation de collecteur, notamment pour un tube à ondes progressives, et comprenant :

- des moyens de polarisation de collecteur (4), fonctionnant essentiellement en source de tension, délivrant entre collecteur (2) et cathode (1) une tension (Vc) faiblement ou non régulée et filtrée, ces moyens ayant l'une de leurs bornes reliée à la cathode et l'autre au collecteur,

- des moyens de polarisation de cathode 8, délivrant à la cathode une tension (Vk) fortement régulée et fortement filtrée de manière à maintenir constant le potentiel de la cathode sur son point de fonctionnement choisi, et

- un condensateur de stockage de charge (10), dont une armature est reliée à la cathode et l'autre à la masse,

Selon l'invention:

- les moyens de polarisation de cathode (8) ont l'une de leurs bornes reliée au collecteur (2) et l'autre à la masse, et

- les moyens de polarisation de collecteur (4) sont montés en série avec les moyens de polarisation de cathode (8) et intercalés entre ceux-ci et la cathode (1), de sorte que la tension de cathode (Vk) soit égale à la somme (Vc + Vg) des tensions délivrées respectivement par les moyens de polarisation de collecteur et les moyens de polarisation de cathode.

De cette manière, les moyens de polarisation de cathode (8), tout en réalisant essentiellement à eux seuls la régulation de la tension de cathode, délivrent une tension (Vg) notablement inférieure à la tension de cathode (Vk) et une puissance notablement inférieure à la puissance de cathode.

FIG. 2

## Alimentation regulée en tension, notamment pour tubes hyperfréquences

La présente invention concerne les alimentations régulées en tension, en particulier les alimentations pour les tubes amplificateurs hyperfréquence qui nécessitent à la fois une alimentation de cathode et une alimentation de collecteur, comme c'est par exemple le cas des TOPs (tubes à ondes progressives).

Dans ces tubes, pour amplifier une onde hyperfréquence, on la fait interagir avec un faisceau électronique.

Ce faisceau électronique est accéléré par un potentiel très haute tension de cathode, typiquement de l'ordre de 40 à 50 kV. A la fin de son interaction avec l'onde hyperfréquence, le faisceau possède encore une énergie cinétique importante que l'on peut :
- soit dissiper par échauffement d'une électrode de collecteur reliée à la masse et frappée par le faisceau après interaction (cas typique des klystrons),
- soit récupérer en faisant franchir au faisceau une barrière ou "dépression" de potentiel créée en portant l'électrode de collecteur à un potentiel donné (cas typique des TOPs). Ce potentiel de collecteur est non nul (sinon on revient au cas précédent) mais inférieur au potentiel de cathode.

Dans ce dernier cas, le tube, qui est dit "à collecteur déprimé" nécessite deux alimentations distinctes :
- en premier lieu, une alimentation très haute tension mais de faible puissance (par exemple une alimentation 40 kV/ 1200 W), chargée de polariser, par rapport à la masse, la cathode au potentiel permettant d'accélérer le faisceau électronique pour le faire interagir avec l'onde hyperfréquence. Il suffit que cette alimentation soit de puissance relativement faible, car son rôle essentiel est de polariser la cathode par rapport à la masse, sans que le flux de courant entre cathode et masse soit important : en effet, la majeure partie du faisceau électronique circule entre cathode et collecteur et il ne circule entre cathode et masse qu'un courant relativement faible, qui est un courant de fuite dû aux imperfections du tube (Ce courant de fuite entre cathode et masse ne dépasse généralement pas 20% du courant total).
- en second lieu, une alimentation haute tension mais de forte puissance (par exemple 30 kV/5000 W) destinée à mettre en dépression le collecteur en le polarisant par rapport à la cathode. Comme on souhaite "pomper" la majeure partie des charges électroniques récupérées sur ce collecteur pour les faire recirculer vers la cathode, cette seconde alimentation doit fournit un courant relativement important, d'où sa puissance relativement élevée.

Jusqu'à présent, on utilisait généralement pour la haute tension de collecteur et la très haute tension de cathode un bloc d'alimentation unique, les deux tensions étant obtenues à partir de deux étages d'un même générateur de tension.

Une telle solution requiert cependant des alimentations de très grande qualité tant en ce qui concerne le bruit de tension résiduel que la stabilité du potentiel délivré.

En effet, bien que le collecteur soit peut sensible au bruit de tension (notamment le bruit secteur résultant d'un filtrage incomplet), puisque son seul rôle est de provoquer la recirculation des charges non utilisées du faisceau électronique, l'alimentation de cathode nécessite en revanche entre cathode et masse une très haute tension qui soit extrêmement stable et extrêmement bien filtrée (typiquement, un bruit inférieur de -30 dB à celui admissible sur le collecteur) afin de ne pas dégrader la qualité de l'onde hyperfréquence amplifiée par le tube.

En ce qui concerne la stabilité exigée, celle-ci est de l'ordre de 1% sur le potentiel de cathode. En revanche, il suffit d'appliquer au collecteur une tension comprise approximativement entre zéro et le tiers de la tension de cathode pour obtenir un fonctionnement satisfaisant, le seul inconvénient d'une tension de collecteur trop faible étant une augmentation de l'échauffement du collecteur (si l'alimentation de celui-ci n'est pas suffisante, on ne pourra pas récupérer la totalité de l'énergie cinétique du faisceau, et donc une partie de celle-ci devra s'évacuer en chaleur).

La présente invention a pour objet de remédier à ces inconvénients, en proposant un ensemble d'alimentation comportant des moyens de polarisation différenciés selon les électrodes, comprenant d'une part une première partie destinée à alimenter le collecteur, qui soit de forte puissance et pour laquelle on puisse accepter, en termes de bruit et d'instabilité, une forte pollution et d'autre part une seconde partie destinée à l'alimentation de la cathode, à faible puissance et faible pollution.

Plus précisément, l'ensemble d'alimentation de l'invention comprend, de manière en elle-même connue :
- des moyens de polarisation de collecteur, fonctionnant essentiellement en source de tension, délivrant entre collecteur et cathode une tension faiblement ou non régulée et filtrée, ces moyens ayant l'une de leurs bornes reliée à la cathode et l'autre au collecteur,
- des moyens de polarisation de cathode, délivrant à la cathode une tension fortement régulée et fortement filtrée de manière à maintenir constant le potentiel de la cathode sur son point de fonctionnement choisi, et

- un condensateur de stockage de charge, dont une armature est reliée à la cathode et l'autre à la masse.

Selon l'invention, cet ensemble d'alimentation est tel que :

- les moyens de polarisation de cathode ont l'une de leurs bornes reliée au collecteur et l'autre à la masse, et

- les moyens de polarisation de collecteur sont montés en série avec les moyens de polarisation de cathode et intercalés entre ceux-ci et la cathode, de sorte que la tension de cathode soit égale à la somme des tensions délivrées respectivement par les moyens de polarisation de collecteur et les moyens de polarisation de cathode,

De cette manière, les moyens de polarisation de cathode, tout en réalisant essentiellement à eux seuls la régulation de la tension de cathode, délivrent une tension notablement inférieure à la tension de cathode et une puissance notablement inférieure à la puissance de cathode.

En d'autres termes, pour polariser la cathode, on remplace une alimentation de cathode (tension appliquée directement entre cathode; et masse) par une alimentation de collecteur agissant indirectement sur la cathode.

En effet, l'alimentation de collecteur, qui est réalisée entre cathode et collecteur, est donc flottante par rapport à la masse, de sorte qu'on peut l'utiliser pour polariser indirectement la cathode.

Grâce à un tel système composite formé de deux générateurs en série, l'alimentation de collecteur décale vers les hautes tensions la plage des tensions de fonctionnement de l'alimentation de cathode ; cette dernière peut donc, tout en assurant un asservissement aussi efficace, fonctionner à la fois sur une tension beaucoup plus faible (par exemple, au maximum d'un tiers de la tension de cathode) et avec une puissance plus faible - celle-ci étant réduite dans le rapport des tensions.

Très avantageusement, les moyens de polarisation de cathode fonctionnent essentiellement en source de courant, asservie sur la tension de cathode.

L'alimentation de cathode ainsi constituée par un générateur de courant peut ainsi imposer au système composite formé par les deux générateurs en série (dont l'un n'est pas asservi) de fonctionner globalement en générateur de courant, avec les avantages qui en découlent du fait de la meilleure régulation : en effet, un générateur de courant - à la différence d'un générateur de tension - procure une réponse du premier ordre, donc réagit de façon beaucoup plus rapide aux différentes variations.

Cette dernière caractéristique est particulièrement importante dans le cas des tubes radars, où l'alimentation doit pouvoir suivre des variations importantes du facteur de forme.

Le principe de l'invention, que l'on vient d'exposer pour l'alimentation d'un tube radar, peut être transposé à l'alimentation de charges quelconques, l'idée générale étant la mise en série d'une source de courant avec une source de tension pour obtenir un générateur de courant à puissance amplifiée.

Dans une telle généralisation :

- la cathode correspond à un noeud de sortie et le collecteur à un point milieu,

- les moyens de polarisation de collecteur correspondent à une première source, fonctionnant essentiellement en source de tension, faiblement ou non régulée et filtrée,

- les moyens de polarisation de cathode correspondent à une seconde source, fonctionnant essentiellement en source de courant, fortement régulée et fortement filtrée mais de tension notablement inférieure à la tension du noeud de sortie et de puissance notablement inférieure à la puissance de sortie.

D'autres caractéristiques et avantages de l'invention apparaîtront à la lecture de la description détaillée ci-dessous, faite en référence aux dessins annexés sur lesquels :

- la figure 1 montre, de façon schématique, une alimentation de tube hyperfréquence selon l'art antérieur,

- la figure 2 est homologue de la figure 1, pour un ensemble d'alimentation selon l'invention,

- la figure 3 montre la variation des différents niveaux de tension sur le collecteur et la cathode au cours du temps,

- la figure 4 illustre un schéma d'alimentation de l'art antérieur, dans le cas d'une généralisation à une charge quelconque,

- la figure 5 est homologue de la figure 4, pour une alimentation réalisée selon les enseignements de la présente invention.

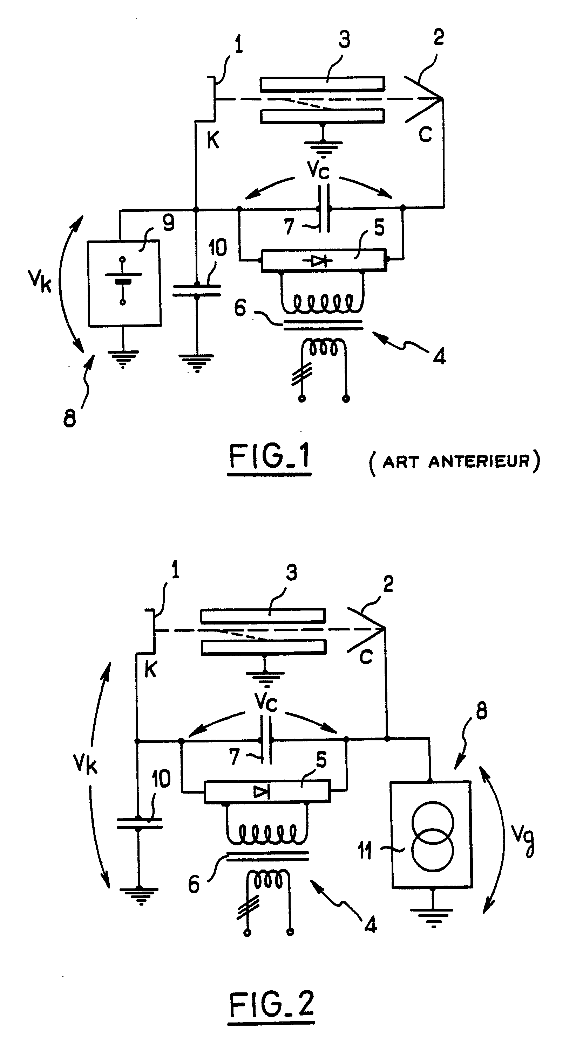

Sur la figure 1, on a représenté un tube du type à collecteur déprimé et son alimentation selon l'art antérieur.

Le tube comporte essentiellement une cathode 1 accélérant un faisceau électronique afin de le faire interagir avec une onde hyperfréquence de manière à amplifier cette dernière, et une électrode de collecteur 2 frappée par le faisceau après interaction. Une faible fraction du faisceau (de l'ordre de 20%) frappe également, en raison des imperfections du tube, une électrode de masse 3.

Pour récupérer l'énergie cinétique du faisceau frappant le collecteur 2, au lieu de mettre celui-ci à la masse, on le "met en dépression" par rapport à la cathode, c'est à dire que l'on crée une barrière de potentiel grâce à des moyens de polarisation de collecteur 4, fonctionnant essentiellement en générateur de tension, produisant une tension Vc entre collecteur et cathode et faisant ainsi recirculer les charges récupérées sur le collecteur pour les renvoyer sur la cathode.

Du fait qu'ils ont pour seul rôle d'assurer cette recirculation de charges, les moyens de polarisation de collecteur n'ont pas ou peu besoin d'être régulés et filtrés.

On peut alors utiliser à cet effet un simple pont redresseur 5 alimenté par un transformateur 6 ; si l'on utilise un redressement triphasé ou hexaphasé et un transformateur présentant une self de fuite assez importante, l'ondulation résiduelle sera de l'ordre de quelques pour-cents, valeur parfaitement acceptable.

L'absence de régulation de l'alimentation de collecteur n'est pas gênante ; le seul inconvénient d'une tension Vc insuffisante sera une incapacité à récupérer la totalité de l'énergie cinétique du faisceau frappant le collecteur, provoquant donc un échauffement de celui-ci. Il suffit donc de dimensionner l'électrode de collecteur en fonction des variations de tension prévisibles ; on peut noter que le tube pourra fonctionner même avec une tension Vc nulle, mais dans ce cas, l'échauffement du collecteur sera maximal (et on revient ainsi au cas de figure des klystrons, où le collecteur est par construction mis à la masse).

De façon optionnelle, en fonction de la nature des courants de collecteur (continus ou pulsés, à variation brutale ou lente), on peut également prévoir un condensateur 7 de stockage de charge, qui améliorera les performances d'ensemble en cas de fréquence de répétition élevée et de facteur de forme critique.

En ce qui concerne l'électrode de cathode 1, celle-ci est polarisée par des moyens de polarisation de cathode 8 constitués par un générateur de tension 9 produisant une très haute tension Vk appliquée entre cathode et masse.

Un condensateur de stockage de charges 10 permet, comme dans le cas du condensateur 7, d'avoir un fonctionnement impulsionnel satisfaisant.

A la différence des moyens de polarisation de collecteur, les moyens de polarisation de cathode 8 doivent être à la fois fortement filtrés et fortement stabilisés, car ils déterminent les performances de fonctionnement hyperfréquence du tube.

Par ailleurs, la tension Vk produite doit être une très haute tension (par exemple de l'ordre de 40 kV), très supérieure à la tension de polarisation Vc du collecteur (typiquement, au moins triple de celle-ci).

En revanche, la puissance que doivent fournir les moyens de polarisation de cathode 8 est inférieure à celle que doivent fournir les moyens de polarisation de collecteur 4 puisque, comme on le voit sur le schéma, ils n'auront qu'à recycler le courant de fuite entre la cathode 1 et l'électrode de masse 3, courant qui ne correspond qu'à environ 20% du flux total d'électrons du faisceau.

Le rapport des puissances des deux alimentations 4 et 8 est ainsi, généralement, de l'ordre de 80%/20%.

Cependant, malgré cette puissance plus faible, l'alimentation de cathode 8 reste coûteuse à réaliser et peu fiable, du fait qu'elle doit procurer une régulation extrêmement fine à la fois sur une très haute tension et avec une puissance qui, bien que relativement plus faible que celle de l'alimentation 4, représente dans l'absolu une valeur importante dans de nombreuses applications (les 20% du courant passant entre cathode et masse peuvent en effet représenter une puissance moyenne de l'ordre de 1200 W).

En outre, les sources de tension régulées sont en général assez peu performantes car, en raison des risques d'accrochage, il est nécessaire de prévoir dans les moyens de rétroaction un filtrage passe-bas, qui a pour inconvénient de réduire la rapidité de réponse de l'asservissement de tension.

Pour pallier ces différents inconvénients, la présente invention propose de modifier le schéma d'alimentation de la figure 1 de telle sorte que les moyens de polarisation de cathode fonctionnent à la fois sur une tension plus basse et une puissance beaucoup plus faible, donc puisse être constituée par des circuits beaucoup moins coûteux et plus fiables que dans l'art antérieur.

La figure 2 illustre le circuit modifié.

Dans ce circuit, on a déplacé les moyens de polarisation de cathode 8 de manière à les monter non plus entre cathode et masse mais entre collecteur et masse. La cathode 1 n'est donc plus polarisée directement, comme c'était le cas sur la figure 1, mais indirectement par les deux moyens de polarisation de collecteur et de cathode, respectivement 4 et 8, mis en série.

Par ailleurs, de préférence, les moyens de polarisation de cathode 8 sont constitués non plus par un générateur de tension, mais par un générateur de courant 11 asservi, c'est à dire dans lequel on commande l'injection d'un courant proportionnel à l'écart entre la tension réelle de cathode Vk et sa consigne.

Ce type de régulation par contrôle de courant possède une réponse du premier ordre et ne présente donc aucun risque d'accrochage et on n'a donc pas besoin de limiter sa bande passante, de sorte qu'il sera beaucoup plus rapide et acceptera sans difficulté toutes les variations du facteur de forme des signaux radars considérés.

Si l'on considère le schéma de la figure 2, on voit que la totalité du courant injecté (au noeud de collecteur) par le générateur de courant 11 se retrouvera aux bornes du condensateur 10 (au noeud de cathode). Ce schéma permet donc le contrôle des courants au noeud de cathode sans être obligé de disposer d'un générateur de courant travaillant à la très haute tension de cathode.

L'avantage de ce système composite à deux générateurs en série est double :
- il réduit la tension Vg que doivent produire les moyens de polarisation de cathode 8, puisque les moyens de polarisation de collecteur 4, placés en série, décalent vers les hautes tensions la plage des tensions de fonctionnement du générateur de courant 8.

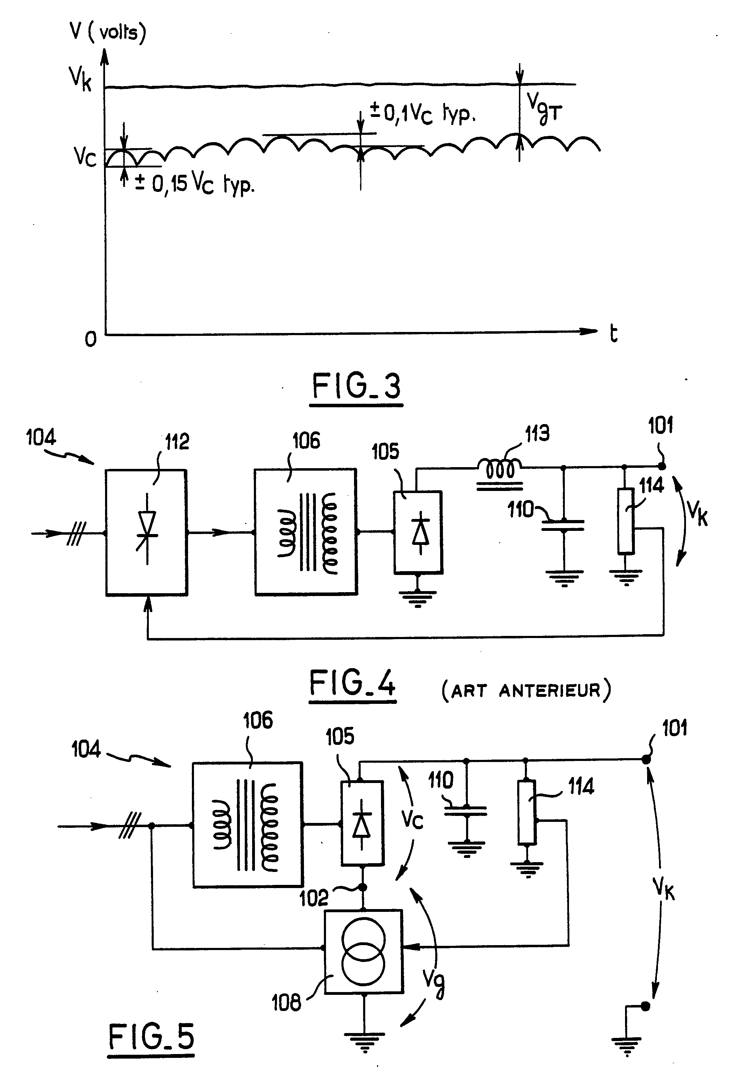

Cet "effet d'ascenseur" est illustré sur la figure 3, où l'on voit que, pour réguler Vk, il suffit de contrôler la tension Vg, beaucoup plus faible que la tension Vk.

On choisit par exemple pour Vg une tension de l'ordre d'un tiers de la tension Vk ; ce rapport n'est pas critique mais est seulement destiné à conserver une marge de sécurité vis-à-vis de la tension résiduelle de ronflement (typiquement, de l'ordre de ±15% de Vc) et des instabilités de cette même tension Vc (typiquement de l'ordre de ±10%), qui peuvent donc, en se cumulant, produire des variations atteignant 25% ; si Vg/Vk = 33%, on sera sûr que le collecteur sera toujours en dépression.
- il réduit la puissance délivrée par les moyens de polarisation de la cathode dans le rapport des tensions.

Ainsi, environ 95% de la puissance délivrée au tube est fourni par une alimentation secteur non régulée, et 5% seulement de la puissance est délivrée par une alimentation régulée, et fonctionnant en outre à tension relativement faible.

Ces avantages sont particulièrement significatifs dans le cas des alimentations pour tubes radar où, pour des questions de synchronisme, on est obligé de prévoir pour la régulation des alimentations à découpage fonctionnant à des fréquences de travail très élevées, de l'ordre de 50 à 120 kHz.

En effet, il est extrêmement difficile, et donc coûteux, de réaliser des alimentations à découpage présentant à la fois une forte puissance et une fréquence élevée de découpage, conditions impératives pour une alimentation de tube radar.

La présente invention permet ainsi, par exemple, de réduire la puissance électrique régulée de 6 kW à 300 W, le reste étant assuré par un bloc THT secteur non régulé.

Le principe de l'invention, que l'on vient d'exposer pour l'alimentation d'un tube radar, peut être généralisé à l'alimentation de charges quelconque, l'idée générale étant la mise en série d'une source de courant régulée avec une source de tension non régulée pour obtenir un générateur de courant à puissance amplifiée.

Cette généralisation est illustrée sur les figures 4 et 5, qui sont homologues des figures 1 et 2 ; les éléments jouant des rôles similaires ont été désignés par les mêmes références numériques auxquelles a été ajoutée la valeur 100 (par exemple, le pont redresseur 105 des figures 4 et 5 correspond au pont redresseur 5 des figures 1 et 2).

Les alimentations régulées de l'art antérieur, illustrées schématiquement figure 4, utilisent généralement un transformateur 106, au primaire de ce transformateur une régulation secteur 112 travaillant en générateur de tension, et au secondaire un redressement 105 et une cellule de filtrage à inductance 113 et capacité 110. Un pont diviseur 114 prélève la tension Vk au noeud de sortie 101 pour contrôler la régulation 112, qui est par exemple un système à découpage à rapport cyclique variable.

Si l'on applique les enseignements de la présente invention, on peut modifier un tel système d'alimentation en supprimant la régulation secteur 112 (qui devait être dimensionnée en fonction de la puissance totale susceptible d'être délivrée par le système d'alimentation).

A cet effet, on place en série avec le pont redresseur 105 un générateur de courant 108 asservi sur la tension au noeud de sortie 101.

On voit que l'on retrouve le schéma de la figure 2, le noeud de sortie 101 jouant le rôle de l'électrode de cathode 1, le point milieu 102 (ici, inutilisé) entre pont redresseur 105 et générateur de courant 108 jouant le rôle du collecteur, le générateur de courant 108 jouant le rôle des moyens de polarisation de cathode 8, et l'ensemble 104 formé du transformateur 106 et du pont redresseur 105 jouant le rôle des moyens de polarisation de collecteur 4.

L'inductance de filtrage 113 peut être supprimée, et le rôle de lissage qui lui était dévolu est alors rempli par le générateur de courant 108 intercalé en série dans le circuit secondaire.

L'avantage est que l'on triple la puissance que peut fournir une alimentation donnée, sans rien céder à la qualité de la régulation.

Enfin, le transformateur secteur 106 travaille dans de bonnes conditions et sur une partie seulement de la puissance à fournir, ce qui conduit, là aussi, à une diminution notable de son encombrement.

Ce transformateur 106 peut être un simple auto-transformateur ou peut même être supprimé, en fonction de l'application envisagée.

Le générateur de courant 108 peut être constitué par une alimentation à découpage à relativement basse tension, donc plus simple et moins onéreuse, la tension brute de base étant essentiellement délivrée aux bornes du pont redresseur 105.

On peut prévoir une tension Vg délivrée par le générateur 108 qui soit de l'ordre d'un tiers ou même moins de la tension de sortie Vk de l'alimentation, la seule condition étant que la dynamique en tension du générateur de courant série 108 puisse s'accommoder des variations (instabilités, ronflement) de la source de tension 105 non régulée.

**Revendications**

1. Un ensemble d'alimentation, pour un tube du type nécessitant à la fois une alimentation de cathode et une alimentation de collecteur, notamment pour un tube à ondes progressives, comprenant :
- des moyens de polarisation de collecteur (4), fonctionnant essentiellement en source de tension, délivrant entre collecteur (2) et cathode (1) une tension (Vc) faiblement ou non régulée et filtrée, ces moyens ayant l'une de leurs bornes reliée à la cathode et l'autre au collecteur,
- des moyens de polarisation de cathode (8), délivrant à la cathode une tension (Vk) fortement régulée et fortement filtrée de manière à maintenir constant le potentiel de la cathode sur son point de fonctionnement choisi, et
- un condensateur de stockage de charge (10), dont une armature est reliée à la cathode et l'autre à la masse,
caractérisé en ce que :
- les moyens de polarisation de cathode (8) ont l'une de leurs bornes reliée au collecteur (2) et l'autre à la masse, et
- les moyens de polarisation de collecteur (4) sont montés en série avec les moyens de polarisation de cathode (8) et intercalés entre ceux-ci et la cathode (1), de sorte que la tension de cathode (Vk) soit égale à la somme (Vc + Vg) des tensions délivrées respectivement par les moyens de polarisation de collecteur et les moyens de polarisation de cathode,
de manière que les moyens de polarisation de cathode (8), tout en réalisant essentiellement à eux seuls la régulation de la tension de cathode, délivrent une tension (Vg) notablement inférieure à la tension de cathode (Vk) et une puissance notablement inférieure à la puissance de cathode.

2. L'ensemble d'alimentation de la revendication 1, dans lequel :
- les moyens de polarisation de cathode (8) fonctionnent essentiellement en source de courant, asservie sur la tension de cathode (Vk).

3. Une alimentation régulée en tension, comprenant :
- une première source (104), fonctionnant essentiellement en source de tension délivrant entre un point milieu (102) et un noeud de sortie (101) une tension (Vc) faiblement ou non régulée et filtrée, cette première source ayant l'une de ses bornes reliée au noeud de sortie et l'autre au point milieu,
- une seconde source (108), délivrant au noeud de sortie une tension (Vk) fortement régulée et fortement filtrée de manière à maintenir constant le potentiel de ce noeud de sortie sur son point de fonctionnement choisi, et
- un condensateur de stockage de charge (110), dont une armature est reliée au noeud de sortie et l'autre à la masse,
caractérisé en ce que :
- la seconde source (108) a l'une de ses bornes reliée au point milieu (102) et l'autre à la masse, et
- la première source (104) est montée en série avec la seconde source (108) et intercalée entre celle-ci et le noeud de sortie (101), de sorte que la tension de ce noeud de sortie (Vk) soit égale à la somme (Vc + Vg) des tensions délivrées respectivement par la première et la seconde source,
de manière que la seconde source (108), tout en réalisant essentiellement à elle seule la régulation de la tension au noeud de sortie, délivre une tension (Vg) notablement inférieure à la tension (Vk) de ce noeud de sortie et une puissance notablement inférieure à la puissance de sortie.

4. L'ensemble d'alimentation de la revendication 3, dans lequel :
- la seconde source (108) fonctionne essentiellement en source de courant, asservie sur le potentiel du noeud de sortie (Vk).

FIG_1 ( ART ANTERIEUR )

FIG_2

EP 0 373 030 A1

FIG_3

FIG_4        (ART ANTERIEUR)

FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-3 723 798  (L.H. O'BRIEN)<br>* Figure; colonne 2, ligne 28 - colonne 3, ligne 21 *<br>--- | 1-4 | H 03 F    3/58<br>H 03 F    3/56 |
| Y | PATENT ABSTRACTS OF JAPAN, vol. 7, no. 272 (E-214)[1417], 3 décembre 1983; & JP-A-58 154 138 (NIPPON DENKI K.K.) 13-09-1983<br>--- | 1-4 | |
| Y | US-A-3 848 197  (B. BOYD et al.)<br>* Figure 1; colonne 2, ligne 9 - colonne 3, ligne 39 *<br>--- | 1-4 | |
| A | FR-A-2 358 015  (TELEFON AG L.M. ERICSSON)<br>* Figures 1,3; page 3, ligne 33 - page 6, ligne 23 *<br>----- | 1,3 | |

DOMAINES TECHNIQUES
RECHERCHES (Int. Cl.5)

H 03 F

Le présent rapport a été établi pour toutes les revendications

| Lieu de la recherche | Date d'achèvement de la recherche | Examinateur |
|---|---|---|
| LA HAYE | 07-03-1990 | TYBERGHIEN G.M.P. |